# EUROPÄISCHE PATENTSCHRIFT

(11) **EP 2 944 503 B1**
(45) Veröffentlichungstag und Bekanntmachung des Hinweises auf die Patenterteilung: **12.01.2022**
(21) Anmeldenummer: 15000299.6
(22) Anmeldetag: 02.02.2015
(51) Int. Cl.: B60L 5/20, G01R 27/20

(54) **Elektrische Leistungsschnittstelle eines Fahrzeugs**
Electrical performance interface of a vehicle
Interface de ligne électrique d'un véhicule automobile

(30) Priorität: 07.05.2014 DE 102014006654
(43) Veröffentlichungstag der Anmeldung: 18.11.2015
(60) Teilanmeldung: 21188277.4
(73) Patentinhaber: MAN Truck & Bus SE, 80995 München (DE)
(72) Erfinder: Schleufe, Stefan, 81245 München (DE); Soboll, Stefan, 85221 Dachau (DE)
(74) Vertreter: v. Bezold & Partner Patentanwälte - PartG mbB

(56) Entgegenhaltungen:
- EP-A1- 2 670 622
- DE-U1-202009 012 471
- JP-A- 2004 314 823
- US-A1- 2009 286 427
- None

## Beschreibung

Die Erfindung betrifft eine elektrische Leistungsschnittstelle eines Fahrzeugs, insbesondere eines Nutzfahrzeugs oder eines Schienenfahrzeugs.

Bei temporären elektrischen Verbindungen ist in der Regel die Qualität der elektrischen Kontaktierung an der Verbindungsstelle und damit der Übergangswiderstand nicht bekannt. Dies kann insbesondere bei Leistungsschnittstellen, über die hohe Leistungen übertragen werden, zu Problemen führen. So kann die Verbindungsschnittstelle bei einer schlechten Kontaktqualität zwischen den die Leistungsschnittstelle ausbildenden Leistungskontakten und einer nicht daran angepassten Übertragungsleistung überlastet werden. Dieses Problem kann insbesondere bei einer temporären Leistungsschnittstelle, bei der Leistungskontakte unter direkten Umwelteinflüssen miteinander in Kontakt gebracht werden, auftreten. Beispiele solcher temporärer Leistungsschnittstellen sind eine externe Ladeschnittstelle eines Plug-In-Hybrid-Fahrzeugs oder ein Stromabnehmer, z. B. ein Pantograph, eines Schienenfahrzeugs oder Omnibusses, der mit einer stromführenden Leitung zur Ausbildung eines Leistungspfades in Kontakt bringbar ist.

Aus der DE 10 2005 042 087 B3 ist ein Verfahren zur Zustandserfassung eines mit einer Stromleitung in Kontakt stehenden Stromabnehmers bekannt, wobei der Stromabnehmer so ausgebildet ist, dass daran Dehnungsmessstellen vorgesehen sind, um dort die durch eine auftretende Kontaktkraft zwischen der Stromleitung und dem Stromabnehmer hervorgerufene mechanische Dehnung des Stromabnehmers zu erfassen. Aus der mechanischen Dehnung können Rückschlüsse auf die Qualität der elektrischen Kontaktierung gezogen werden. Nachteilig an dem bekannten Verfahren ist, dass es speziell für Stromabnehmer von Stromleitungen konzipiert ist und sich nicht ohne Weiteres auf andere Leistungsschnittstellen übertragen lässt, wo in der Regel keine leicht erfassbare mechanische Dehnung eines Leistungskontakts auftritt oder diese zumindest nicht mit der Qualität der elektrischen Kontaktierung korreliert. Ein weiterer Nachteil ist, dass das Verfahren durch die erforderliche Einbringung von Dehnungsmessstellen eine vergleichsweise komplexe Ausgestaltung des Stromabnehmers erfordert.

Aus der WO 2005 044 614 A1 ist bekannt, die Temperatur an einer elektrischen Leistungsschnittstelle zu bestimmen und aus der gemessenen Temperatur Rückschlüsse auf die Qualität der elektrischen Kontaktierung zu ziehen. Nachteilig an dem beschriebenen Stromabnehmer ist, dass zur Temperaturmessung ein Faser-Bragg-Gitter zur Temperaturmessung und ferner eine entsprechend aufwändig ausgeführte Einrichtung zur Auswertung der Sensorsignale benötigt werden.

In der DE 10 2010 026 435 A1 wird ebenfalls vorgeschlagen, zur Klassifizierung einer elektrischen Kontaktierung zwischen einem ersten Anschlusselement einer Batterie und einem zweiten Anschlusselement einen Temperatursensor vorzusehen und mittels einer Steuereinrichtung basierend auf dem Erfassungssignal des Temperatursensors die elektrische Kontaktierung zu klassifizieren. Als eine weitere Variante wird ferner vorgeschlagen, an zwei Leistungskontaktpaaren jeweils zusätzlich eine Spannung zu bestimmen, die an den miteinander in Kontakt stehenden Leistungskontakten eines Leistungskontaktpaares anliegt, und anschließend mittels einer Differenzbetrachtung der beiden Spannungswerte Rückschlüsse auf die Qualität der elektrischen Kontaktierung zu ziehen. Nachteilig an dem beschriebenen Ansatz ist, dass sowohl eine Temperaturmessung als auch eine Spannungsmessung an zwei verschiedenen Messstellen, d. h. an zwei unterschiedlichen Leistungskontaktpaaren, benötigt wird und somit aufwändig zu realisieren ist. Ein weiterer Nachteil ist, dass der vorgeschlagene Ansatz zur Spannungsmessung keine Rückschlüsse auf die Qualität einer einzelnen elektrischen Kontaktierung zwischen zwei Leistungskontakten eines Leistungskontaktpaares ermöglicht, sondern lediglich eine Aussage über die Kontaktqualität in Summe einer Anordnung bestehend aus zwei Leistungskontaktpaaren und den dazwischen angeordneten Leitungen.

Die DE 20 2009 012 471 U1 offenbart eine Messeinrichtung zur kontinuierlichen Erfassung des Übergangswiderstandes zwischen einer Stromleitung und einem Schleifkontakt eines Stromabnehmers für ein elektrisch betriebenes Fahrzeug. Zwei Schleifkontakte liegen voneinander potential getrennt an der Stromleitung, die eine Fahrleitung oder eine Stromschiene sein kann, gleitend an. Ein Schleifkontakt dient der Übertragung des elektrischen Stroms für die Versorgung des Fahrzeuges, wobei dessen Übergangswiderstand zusammen mit dem Innenwiderstand des Fahrzeuges einen ersten Spannungsteiler mit einem Abgriff bildet. Der zweite Schleifkontakt ergibt mit seinem Übergangswiderstand zusammen mit einem hochohmigen Widerstand einen zweiten Spannungsteiler mit einem Abgriff, an dem eine Referenzspannung anliegt. Die Spannungsteiler mit den Abgriffen sind mit einem Datenerfassungsgerät verbunden sind, mit dem in an sich bekannter Weise über eine Messung der Spannungsdifferenz über die Schleifkontakte und des Stroms für die Versorgung des Fahrzeuges der Übergangswiderstand des Schleifkontakts erfasst wird.

Die EP 2 670 622 A1 offenbart ein Verfahren zum Schutz eines Ladekabels bei einer Ladeeinrichtung zum Laden einer Fahrbatterie eines elektrisch antreibbaren Fahrzeugs. Bei diesem Verfahren wird ein Widerstandswert ermittelt, der der Größe des elektrischen Widerstands zwischen zwei Kontakten des Ladekabels entspricht, wobei die Größe des elektrischen Widerstands die Stromtragfähigkeit des Ladekabels angibt. In Abhängigkeit von dem ermittelten Widerstandswert wird eines von mehreren bei der Ladeeinrichtung angeordneten Leitungsschutzgeräten in den Ladestrompfad geschaltet.

Die EP 2 301 118 A1 offenbart eine Verbinderanordnung, umfassend ein längliches Element, wobei das längliche Element mindestens zwei elektrisch leitende Bereiche an seiner Außenfläche umfasst. Die mindestens zwei elektrisch leitenden Bereiche sind voneinander isoliert und bilden einen ersten Verbinder. Ein zweiter Verbinder ist innerhalb des länglichen Elements angeordnet und von einer Endfläche des länglichen Elements zugänglich, wobei der zweite Verbinder so konfiguriert ist, dass er unabhängig von dem ersten Verbinder verwendet werden kann.

Es ist somit eine Aufgabe der Erfindung, eine elektrische Leistungsschnittstelle bereitzustellen, mit der Nachteile herkömmlicher elektrischer Leistungsschnittstellen vermieden werden können. Der Erfindung liegt insbesondere die Aufgabe zugrunde, eine temporäre elektrische Leistungsschnittstelle bereitzustellen, bei der eine Zustandserfassung einer elektrischen Kontaktierung zwischen den Leistungskontakten eines Leistungskontaktpaares erfasst werden kann.

Diese Aufgaben werden durch eine elektrische Leistungsschnittstelle eines Fahrzeugs, insbesondere eines Nutzfahrzeugs oder eines Schienenfahrzeugs, gemäß den Merkmalen des Hauptanspruchs gelöst. Vorteilhafte Ausführungsformen und Anwendungen der Erfindung sind Gegenstand der abhängigen Ansprüche und werden in der folgenden Beschreibung unter teilweiser Bezugnahme auf die Figuren näher erläutert.

Die elektrische Leistungsschnittstelle umfasst einen ersten Leistungskontakt, der zur Herstellung eines elektrischen Leistungspfades mit einem zweiten Leistungskontakt in Kontakt bringbar ist. Der erste Leistungskontakt stellt somit ein erstes elektrisches Anschlusselement eines Leistungskontaktpaares dar, das zur Ausbildung einer elektrischen Kontaktierung mit einem zweiten elektrischen Anschlusselement in Kontakt bringbar ist. Unter einer elektrischen Leistungsschnittstelle eines Fahrzeugs im Sinne dieser Erfindung wird eine elektrische Schnittstelle verstanden, die zur Energieübertragung, beispielsweise zur Übertragung von Energie, die zum Antrieb des Fahrzeugs genutzt wird, ausgebildet ist, im Unterschied zur einer elektrischen Signalschnittstelle, die zur Signalübertragung ausgebildet ist. Beispiele solcher Leistungsschnittstellen von Fahrzeugen sind eine externe Ladeschnittstelle eines Plug-In-Hybrid-Fahrzeugs oder ein nicht durch die beanspruchte Erfindung abgedeckter Stromabnehmer, z. B. ein Pantograph, eines Schienenfahrzeugs oder Omnibusses, der mit einer stromführenden Leitung zur Ausbildung eines Leistungspfades in Kontakt bringbar ist.

Die elektrische Leistungsschnittstelle umfasst ferner einen Hilfskontakt, der elektrisch isoliert zu dem ersten Leistungskontakt angeordnet ist. Der Hilfskontakt ist ferner so zu dem ersten Leistungskontakt angeordnet, dass, wenn der erste Leistungskontakt und der zweite Leistungskontakt zur Ausbildung des elektrischen Leistungspfades miteinander in Kontakt gebracht sind, der Hilfskontakt den zweiten Leistungskontakt ebenfalls elektrisch kontaktiert, wobei der Hilfskontakt über einen Messpfad elektrisch parallel zu dem ersten Leistungskontakt geschaltet ist.

Ferner kann eine Messeinrichtung zur Zustandserfassung einer elektrischen Kontaktierung zwischen dem ersten Leistungskontakt und dem zweiten Leistungskontakt vorgesehen sein, die ausgeführt ist, über den Messpfad einen Spannungsabfall an der elektrischen Leistungsschnittstelle und/oder eine mit dem Spannungsabfall korrelierende Größe zu bestimmen. Die Messeinrichtung kann beispielsweise eine Spannungsmesseinrichtung sein, die die Spannungsdifferenz zwischen dem Hilfskontakt und dem ersten Leistungskontakt misst, die von der Qualität der elektrischen Kontaktierung zwischen dem ersten Leistungskontakt und dem zweiten Leistungskontakt abhängig ist. Mit anderen Worten wird der Übergangswiderstand an der Leistungsschnittstelle bestimmt.

Ein besonderer Vorzug der vorliegenden Erfindung liegt somit darin, dass mittels einer einfachen konstruktiven Erweiterung einer herkömmlichen Leistungsschnittstelle durch Vorsehen des Hilfskontakts und des Messpfades der Übergangswiderstand der elektrischen Kontaktierung gemessen werden kann und es somit möglich ist, die Qualität der elektrischen Kontaktierung eines einzelnen Leistungskontaktpaares zu erfassen und zu bewerten.

Es wird betont, dass die Bezeichnung "erster" Leistungskontakt und "zweiter" Leistungskontakt willkürlich gewählt ist und lediglich zum Ausdruck bringen soll, dass der Hilfskontakt an einem der beiden Leistungskontakte eines Leistungskontaktpaares angeordnet ist.

Gemäß einer besonders bevorzugten Ausgestaltungsform ist die elektrische Leistungsschnittstelle eine temporäre Leistungsschnittstelle. Eine temporäre Leistungsschnittstelle im Sinne dieser Erfindung ist eine mechanisch trennbare elektrische Leistungsschnittstelle, beispielsweise eine Steckverbindung. Der Begriff "temporär" soll daher zum Ausdruck bringen, dass die beiden die Leistungsschnittstelle ausbildenden Kontakte lösbar miteinander in Verbindung gebracht werden können. Die temporäre Leistungsschnittstelle ist somit eine elektrische Schnittstelle, bei der über den ersten Leistungskontakt und den zweiten Leistungskontakt eine temporäre elektrische Verbindung herstellbar ist. Beispielsweise können der erste Leistungskontakt und der zweite Leistungskontakt in Abhängigkeit von einem Betriebszustand des Fahrzeugs in Kontakt oder außer Kontakt sein. Eine solche temporäre elektrische Verbindung kann auch mehrere Stunden oder Tage andauern, beispielsweise beim Laden eines Plug-In-Hybridfahrzeugs über seine externe Ladeschnittstelle.

Bei einer vorteilhaften Variante dieser Ausgestaltungsform kann die temporäre Leistungsschnittstelle eine Ladeschnittstelle eines Plug-in-Hybridfahrzeugs zum Anschluss einer externen elektrischen Energiequelle sein. Gemäß einer nicht durch die beanspruchte Erfindung abgedeckten Variante kann der erste Leistungskontakt ein Stromabnehmer für eine Fahrleitung eines Schienenfahrzeugs oder eines Omnibusses sein.

Der Hilfskontakt und Messpfad können für im Vergleich zum ersten Leistungskontakt vernachlässigbar kleine Ströme ausgelegt sein. Ferner kann die Messeinrichtung so ausgeführt sein, dass der Strom durch die Messeinrichtung vernachlässigbar klein ist, was beispielsweise in Näherung durch den sehr großen und im Idealfall unendlich hohen Innenwiderstand der Messeinrichtung, die beispielsweise als Spannungsmesser ausgeführt ist, erfüllt ist. Ferner kann der Messpfad so ausgeführt sein, dass der Spannungsverlust in dem Messpfad vernachlässigbar klein ist.

Mit anderen Worten können der Hilfskontakt, der Messpfad und/oder die Messeinrichtung so ausgelegt sein, dass kein oder ein vernachlässigbar kleiner Strom fließt, falls mittels der Messeinrichtung über den Hilfskontakt und den Messpfad der Spannungsabfall oder ein Übergangswiderstand unter Last an der Leistungsschnittstelle bestimmt wird. Der Hilfskontakt ist somit vorzugsweise nicht als Leistungskontakt ausgelegt. Dadurch kann die Höhe des Übergangswiderstands bzw. die Höhe des Spannungsabfalls unter Last und damit die Qualität der elektrischen Kontaktierung genau bestimmt werden.

Eine Möglichkeit der erfindungsgemäßen Realisierung sieht vor, dass der Messpfad eine erste Leitung, die am ersten Leistungskontakt kontaktiert ist, und eine zweite Leitung, die am Hilfskontakt kontaktiert ist, aufweist.

Gemäß einem weiteren Ausführungsbeispiel kann die externe Leistungsschnittstelle eine Steuereinrichtung umfassen, die ausgebildet ist, die über den elektrischen Leistungspfad zu übertragende Leistung zu reduzieren oder die Übertragung von elektrischer Leistung über den elektrischen Leistungspfad zu beenden, falls der mittels der Messeinrichtung unter Last gemessene Spannungsabfall oder die mit dem Spannungsabfall korrelierende Größe einen vorbestimmten Schwellwert überschreitet.

Somit kann bei einer unzulässigen Höhe des Übergangswiderstands bzw. des Spannungsabfalls unter Last die zu übertragene Leistung bis hin zur Abschaltung reduziert werden, um eine Überlastung und Beschädigung der Leistungsschnittstelle zu vermeiden.

Die Erfindung ist hinsichtlich der konstruktiven Ausgestaltung des ersten und des zweiten Leistungskontakts bzw. der Art der elektrischen Leistungsschnittstelle nicht auf einen bestimmten Aufbau und Typ beschränkt, sofern diese in den Bereich der beigefügten Ansprüche fallen.

Erfindungsgemäß umfasst die elektrische Leistungsschnittstelle einen Stecker, der mit einem als Teil einer Steckerbuchse ausgeführten zweiten Leistungskontakt in Kontakt bringbar ist. Sowohl der erste Leistungskontakt als auch der Hilfskontakt sind als ein Abschnitt eines Steckelements des Steckers ausgebildet, die durch einen elektrisch isolierenden Abschnitt des Steckelements miteinander verbunden sind. Unter dem Steckelement wird der Teil des Steckers verstanden, der in eine entsprechend ausgeführte Buchsenöffnung der Steckerbuchse zur elektrischen Kontaktierung eingebracht wird.

Gemäß einer Variante dieses Ausführungsbeispiels kann der Hilfskontakt an einem Endabschnitt des Steckelements angeordnet sein. Diese Variante ermöglicht eine Modifikation herkömmlicher Leistungsschnittstellen mit einem geringen konstruktiven Aufwand.

Hierbei besteht die Möglichkeit, dass der Hilfskontakt an demjenigen Endabschnitt des Steckelements angeordnet ist, der im in der Buchse eingesteckten Zustand des Steckers zugewandt zu einer Einstecköffnung der Buchse ist. Diese Anordnung bietet den besonderen Vorteil, dass der Hilfskontakt am hinteren Ende des Steckelements in Bezug auf die Einsteckrichtung ist und somit tendenziell einen etwas schlechteren Übergangswiderstand "sieht", als wenn er an dem gegenüberliegenden Endbereich angeordnet wäre. Diese Anordnung des Hilfskontakts ermöglicht somit eine besonders empfindliche Erfassung einer unzureichenden Qualität der Verbindungsstelle, die beispielsweise auch durch ein unvollständiges Einführen des Steckelements in die Buchsenöffnung hervorgerufen werden kann.

Gemäß einer alternativen Variante besteht jedoch auch die Möglichkeit, dass der Hilfskontakt an demjenigen Endabschnitt des Steckers angeordnet ist, der im in der Buchse eingesteckten Zustand des Steckers zu der Einstecköffnung der Buchse abgewandt und somit dem Buchsenboden oder -ende zugewandt ist. Ferner kann gemäß einer weiteren Variante der Hilfskontakt an einem mittleren Abschnitt des Steckers oder auch an einem beliebigen Abschnitt des Steckers vorgesehen sein.

Ein weiterer Aspekt der Erfindung betrifft ein Fahrzeug, insbesondere ein Nutzfahrzeug oder ein Schienenfahrzeug, mit einer elektrischen Leistungsschnittstelle nach einem der vorhergehenden Aspekte. Beispielsweise kann das Fahrzeug als Omnibus und der erste Leistungskontakt gemäß einer nicht durch die beanspruchte Erfindung abgedeckten Ausführungsform als ein Stromabnehmer, vorzugsweise als Stempel oder Pantograph, für eine stromführende Fahrleitung ausgeführt sein. Eine weitere Möglichkeit der erfindungsgemäßen Realisierung sieht vor, dass das Fahrzeug als Nutzfahrzeug und der erste Leistungskontakt als eine Ladeschnittstelle zum Anschluss einer externen elektrischen Energiequelle ausgeführt sind.

Weitere Einzelheiten und Vorteile der Erfindung werden im Folgenden unter Bezug auf die beigefügten Zeichnungen beschrieben. Es zeigen:
- Figur 1: eine schematische Prinzipdarstellung einer Leistungsschnittstelle gemäß einem ersten Ausführungsbeispiel;
- Figur 2: eine schematische Prinzipdarstellung einer Leistungsschnittstelle gemäß einem nicht durch die beanspruchte Erfindung abgedeckten Ausführungsbeispiel; und
- Figur 3: eine schematische Prinzipdarstellung des Messprinzips.

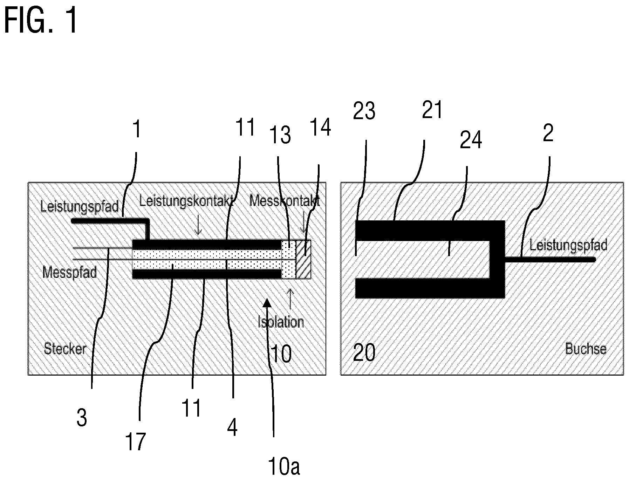

Figur 1 illustriert lediglich schematisch einen Stecker 10 einer temporären Leistungsschnittstelle im Querschnitt mit einem zylinderförmigen Steckelement 10a, das zur Herstellung eines elektrischen Leistungspfades in eine entsprechende Steckerbuchse 20 aufgenommen werden kann. Die mit den fett dargestellten Linien 1, 11, 21, 2 gezeigten Komponenten bilden dabei den Leistungspfad aus. Hierbei wird zur Ausbildung eines Leistungspfades der Leistungskontakt 11 des Steckelements 10a in den buchsenförmig ausgeführten zweiten Leistungskontakt 21 der Steckerbuchse 20, der einen zylinderförmigen Hohlraum 24 ausbildet, gesteckt, derart, dass die äußere Zylindermantelfläche des Leistungskontakts 11 die innere Zylindermantelfläche des zweiten Leistungskontakts 21 zur Ausbildung eines elektrischen Kontakts berührt. Mit den Bezugszeichen 1 und 2 sind jeweils die Anschlussleitungen für den Leistungspfad bezeichnet.

Wird der Leistungskontakt 11 verkantet oder nicht vollständig in die Buchse des Leistungskontakts 21 eingeführt oder ist die elektrische Kontaktierung zwischen dem Leistungskontakt 11 und dem Leistungskontakt 21 anderweitig, z. B. aufgrund von Verschmutzungen auf den Kontaktoberflächen, beeinträchtigt, kann es zu Überlastungen an der elektrischen Leistungsschnittstelle kommen.

Um einen Zustand der elektrischen Kontaktierung erfassen zu können, ist im Unterschied zu einem herkömmlichen Leistungskontakt am ersten Leistungskontakt 11 ferner ein Hilfskontakt 14 vorgesehen, der über einen Isolationsabschnitt 13 elektrisch isoliert an dem ersten Leistungskontakt 11 ortsfest angeordnet ist.

Hierbei ist der Hilfskontakt 14 so am ersten Leistungskontakt 11 angeordnet, dass, wenn der erste Leistungskontakt 11 in den buchsenförmig ausgeführten zweiten Leistungskontakt 21 aufgenommen ist, der Hilfskontakt 14 ebenfalls elektrisch in Kontakt mit dem zweiten Leistungskontakt 21 ist (in Figur 1 nicht dargestellt).

Ferner ist ein Messpfad vorgesehen, gebildet aus einer ersten Messleitung 3, die am ersten Leistungskontakt 11 kontaktiert ist, und einer zweiten Messleitung 4, die am Hilfskontakt 14 kontaktiert ist, so dass der Hilfskontakt 14 über den Messpfad 3, 4 elektrisch parallel zu dem ersten Leistungskontakt 11 geschaltet ist.

Im vorliegenden Beispiel ist die elektrisch leitende Kontaktfläche des zylinderförmigen ersten Leistungskontakts 11 auf einem isolierenden Material 17 angeordnet, das im Inneren des zylinderförmigen ersten Leistungskontakts 11 verläuft. Die Messleitung 4 des Messpfads verläuft durch das isolierende Material 17, um diese von den elektrisch leitenden Kontaktflächen des ersten Leistungskontakts elektrisch zu isolieren.

Die beiden Messleitungen 3, 4 des Messpfads führen zu einer Messeinrichtung (nicht gezeigt), die die Spannungsdifferenz zwischen dem Hilfskontakt 14 und dem ersten Leistungskontakt 11 misst, die abhängig ist von der Kontaktqualität zwischen dem ersten Leistungskontakt 11 und dem zweiten Leistungskontakt 21.

Somit kann der Übergangswiderstand der elektrischen Kontaktierung des Leistungskontaktpaares 11, 21 gemessen werden. Ist beispielsweise die über den Messpfad von der Messeinrichtung gemessene Spannung größer als ein vorbestimmter Schwellwert, kann dies als Zeichen für einen zu hohen Übergangswiderstand an dem Leistungskontaktpaar 11, 21 angesehen werden.

Eine Steuereinrichtung (nicht gezeigt) ist vorgesehen und ausgebildet, die über den elektrischen Leistungspfad zu übertragene Leistung zu reduzieren oder die Übertragung von elektrischer Leistung über den elektrischen Leistungspfad zu beenden, falls der mittels der Messeinrichtung unter Last gemessene Spannungsabfall oder die mit dem Spannungsabfall korrelierende Größe einen vorbestimmten Schwellwert überschreitet.

Im Unterschied zu den Leistungskontakten 11 und 21 kann der Hilfskontakt 14, der lediglich als Messkontakt dient, für, im Vergleich zu den über das Leistungskontaktpaar 11, 21 fließenden Strömen, kleine Ströme ausgelegt werden. Mit anderen Worten sind der Hilfskontakt 14, der Messpfad 3, 4 und die Messeinrichtung so ausgelegt, dass bei einer Messung des Spannungsabfalls und/oder der mit dem Spannungsabfall korrelierenden Größe in Form des Übergangswiderstands über den Hilfskontakt 14 und den Messpfad 3, 4 kein oder ein vernachlässigbar kleiner Strom fließt.

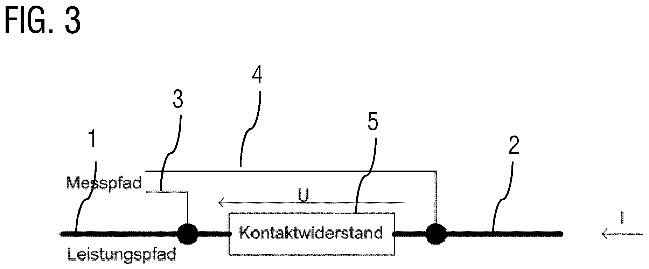

In diesem Zusammenhang wird auf Figur 3 verwiesen, die schematisch nochmals das Messprinzip illustriert. Der Leistungspfad ist wiederum mittels der Anschlussleitungen 1 und 2 gezeigt. Je nach Qualität der elektrischen Kontaktierung zwischen dem ersten Leistungskontakt und dem zweiten Leistungskontakt wird ein unterschiedlicher Kontaktwiderstand 5 (Übergangswiderstand) an der Leistungsschnittstelle ausgebildet, durch die ein Leistungsstrom I fließt. Angelehnt an das Prinzip der Vier- und Dreileitermessung wird mittels des Hilfskontakts und des Messpfades 3, 4 ein vernachlässigbar kleiner Messstrom eingespeist und parallel dazu die Spannung U, die am Kontaktwiderstand anfällt, abgegriffen, aus der direkt ein Maß für den Zustand der elektrischen Kontaktierung zwischen den beiden Leistungskontakten des Kontaktpaares abgeleitet werden kann.

Das in Figur 1 gezeigte Ausführungsbeispiel kann beispielsweise zur Realisierung einer Ladeschnittstelle für ein Hybrid-Fahrzeug zum Anschluss einer externen elektrischen Energiequelle verwendet werden.

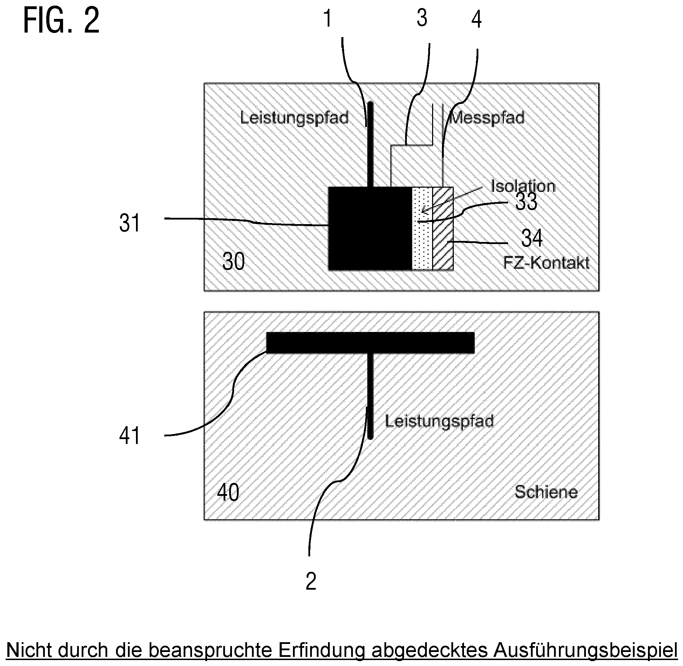

Figur 2 illustriert schematisch ein nicht durch die beanspruchte Erfindung abgedecktes Ausführungsbeispiel zur Realisierung einer temporären Leistungsschnittstelle zwischen einem Fahrzeugkontakt 30, z. B. eines Omnibusses oder Schienenfahrzeugs, und einer Schiene 40. Figur 2 zeigt schematisch eine Querschnittsansicht in Längsrichtung der Schiene 40.

Hierbei ist der Fahrzeugkontakt 30 mit einem stempelförmigen Stromabnehmer 31 ausgestattet, der in Kontakt mit einer stromführenden Fahrschiene 41 bringbar ist (Figur 2 zeigt wiederum nur den Zustand, in dem der Stromabnehmer 31 nicht in Kontakt mit der Stromschiene 41 ist).

Mit den Bezugszeichen 1 und 2 sind wiederum die Leistungsanschlüsse des Leistungspfades bezeichnet. Derartige Stromabnehmer 31 bei Omnibussen sind an sich aus dem Stand der Technik bekannt und müssen hier nicht detaillierter beschrieben werden.

Im Unterschied zu herkömmlichen Stromabnehmern ist gemäß dem Ausführungsbeispiel wiederum ein Hilfskontakt 34 über eine elektrische Isolierung 33 an dem Stromabnehmer 31 befestigt, derart, dass, wenn der Stromabnehmer in Kontakt mit der Fahrschiene 41 gebracht wird, der Hilfskontakt 34 ebenfalls auf der Oberfläche der Fahrschiene 41 aufliegt und diese elektrisch kontaktiert.

Der Hilfskontakt 34 ist wiederum über einen Messpfad 3, 4 elektrisch parallel zu dem Stromabnehmer 31 geschaltet. Der Messpfad umfasst eine erste Messleitung 3, die an dem Stromabnehmer 31 elektrisch kontaktiert ist, und eine zweite Messleitung 4, die an dem Hilfskontakt 34 kontaktiert ist. Wiederum nicht gezeigt ist die Messeinrichtung zur Zustandserfassung der elektrischen Kontaktierung zwischen dem Stromabnehmer 31 und der Fahrschiene 41, die mit den beiden Messleitungen 3, 4 des Messpfades verbunden ist und den Spannungsabfall zwischen dem Hilfskontakt 34 und dem Stromabnehmer 31 misst. Der messbare Spannungsabfall ist wiederum abhängig von der Kontaktqualität und damit dem entstehenden Übergangswiderstand zwischen dem Stromabnehmer 31 und der Fahrschiene 41.

Ferner ist anzumerken, dass eine Leistungsschnittstelle in analoger Weise für einen Oberleitungsstromabnehmer, auch Pantograph genannt, realisierbar ist. Gemäß dieser Abwandlung wäre die Darstellung in Figur 2 um 180° gedreht, und die Fahrleitung 41 wäre in dieser Variante als Oberleitung und der Stromabnehmer 31 als Pantograph ausgebildet.

Obwohl die Erfindung unter Bezugnahme auf bestimmte Ausführungsbeispiele beschrieben worden ist, ist eine Vielzahl von Varianten und Abwandlungen möglich, die ebenfalls von dem Erfindungsgedanken Gebrauch machen und deshalb in den Schutzbereich fallen. Folglich soll die Erfindung nicht auf die offenbarten bestimmten Ausführungsbeispiele begrenzt sein, sondern die Erfindung soll alle Ausführungsbeispiele umfassen, die in den Bereich der beigefügten Patentansprüche fallen.

### Bezugszeichenliste

- 1, 2: Anschlussleitungen des Leistungspfades
- 3, 4: Messleitungen des Messpfades
- 5: Kontaktwiderstand
- 10: Stecker
- 10a: Steckelement
- 11: Erster Leistungskontakt
- 13, 33: Elektrische Isolierung zwischen Hilfskontakt und erstem Leistungskontakt
- 14, 34: Hilfskontakt
- 17: Elektrische Isolierung
- 20: Buchse
- 21: Zweiter Leistungskontakt
- 23: Einstecköffnung
- 24: Aufnahmehohlraum
- 30: Fahrzeugkontakt
- 31: Stromabnehmer
- 40: Schiene
- 41: Fahrschiene

## Patentansprüche

1. Elektrische Leistungsschnittstelle eines Fahrzeugs, insbesondere eines Nutzfahrzeugs oder eines Schienenfahrzeugs, umfassend
einen ersten Leistungskontakt (11; 31), der zur Herstellung eines elektrischen Leistungspfades mit einem zweiten Leistungskontakt (21; 41) in Kontakt bringbar ist;
einen Hilfskontakt (14; 34), der elektrisch isoliert zu dem ersten Leistungskontakt (11; 31) angeordnet ist und der so zu dem ersten Leistungskontakt (11; 31) angeordnet ist, dass, wenn der erste Leistungskontakt (11; 31) und der zweite Leistungskontakt (21; 41) zur Ausbildung des elektrischen Leistungspfades miteinander in Kontakt gebracht sind, der Hilfskontakt (14; 34) den zweiten Leistungskontakt (21; 41) ebenfalls kontaktiert, wobei der Hilfskontakt (14; 34) über einen Messpfad (3,4) elektrisch parallel zu dem ersten Leistungskontakt (11; 31) geschaltet ist; und
eine Messeinrichtung zur Zustandserfassung einer elektrischen Kontaktierung zwischen dem ersten Leistungskontakt (11; 31) und dem zweiten Leistungskontakt (21; 41), die ausgeführt ist, über den Messpfad (3, 4) einen Spannungsabfall an der elektrischen Leistungsschnittstelle und/oder eine mit dem Spannungsabfall korrelierende Größe zu bestimmen, wobei die Messeinrichtung eine Spannungsmesseinrichtung ist, die die Spannungsdifferenz zwischen dem Hilfskontakt und dem ersten Leistungskontakt misst, **gekennzeichnet durch**
einen Stecker (10), der mit einem als Buchse (20) ausgeführten zweiten Leistungskontakt (21) in Kontakt bringbar ist, wobei sowohl der erste Leistungskontakt (11) als auch der Hilfskontakt (14) als ein Abschnitt eines Steckelements (10a) des Steckers (10) ausgebildet sind, die über einen elektrisch isolierenden Abschnitt (13) des Steckelements (10a) miteinander verbunden sind.

2. Elektrische Leistungsschnittstelle nach Anspruch 1, **dadurch gekennzeichnet, dass** die elektrische Leistungsschnittstelle eine temporäre Leistungsschnittstelle ist.

3. Elektrische Leistungsschnittstelle nach Anspruch 1 oder 2, **dadurch gekennzeichnet,**
**dass** die Leistungsschnittstelle eine Ladeschnittstelle eines Plug-in-Hybridfahrzeugs zum Anschluss einer externen elektrischen Energiequelle ist.

4. Elektrische Leistungsschnittstelle nach einem der vorhergehenden Ansprüche, **dadurch gekennzeichnet,**
(a) **dass** der Hilfskontakt (14; 34) und der Messpfad (3, 4) für im Vergleich zum ersten Leistungskontakt vernachlässigbar kleine Ströme ausgelegt sind; und/oder
(b) **dass** der Hilfskontakt (14; 34), der Messpfad (3, 4) und/oder die Messeinrichtung so ausgelegt sind, dass bei einer Messung des Spannungsabfalls oder der mit dem Spannungsabfall korrelierenden Größe mittels der Messeinrichtung über den Hilfskontakt (14; 34) und den Messpfad (3, 4) kein oder ein vernachlässigbar kleiner Strom fließt; und/oder
(c) **dass** der Messpfad (3, 4) eine erste Leitung (3), die am ersten Leistungskontakt (11; 31) kontaktiert ist, und eine zweite Leitung (4), die am Hilfskontakt (14; 34) kontaktiert ist, aufweist.

5. Elektrische Leistungsschnittstelle nach einem der vorhergehenden Ansprüche, **gekennzeichnet durch** eine Steuereinrichtung, die ausgebildet ist, die über den elektrischen Leistungspfad zu übertragende Leistung zu reduzieren oder die Übertragung von elektrischer Leistung über den elektrischen Leistungspfad zu beenden, falls der mittels der Messeinrichtung unter Last gemessene Spannungsabfall oder die mit dem Spannungsabfall korrelierende Größe einen vorbestimmten Schwellwert überschreitet.

6. Elektrische Leistungsschnittstelle nach einem der vorhergehenden Ansprüche, **dadurch gekennzeichnet, dass** der Hilfskontakt (14) an einem Endabschnitt des Steckelements (10a) angeordnet ist.

7. Elektrische Leistungsschnittstelle nach Anspruch 6, **dadurch gekennzeichnet,**
(a) **dass** der Hilfskontakt (14) an demjenigen Endabschnitt des Steckelements (10a) angeordnet ist, der im in der Buchse (20a) eingesteckten Zustand des Steckers (10) zugewandt zu einer Einstecköffnung (23) der Buchse (20) ist; oder
(b) **dass** der Hilfskontakt an demjenigen Endabschnitt des Steckers angeordnet ist, der im in der Buchse eingesteckten Zustand des Steckers zu der Einstecköffnung (23) der Buchse (20) abgewandt ist.

8. Elektrische Leistungsschnittstelle nach einem der vorhergehenden Ansprüche, **dadurch gekennzeichnet, dass** der Hilfskontakt an einem mittleren Abschnitt des Steckers vorgesehen ist.

9. Fahrzeug, insbesondere Nutzfahrzeug oder Schienenfahrzeug, mit einer elektrischen Leistungsschnittstelle nach einem der vorhergehenden Ansprüche.

10. Fahrzeug nach Anspruch 9, **dadurch gekennzeichnet,**
**dass** das Fahrzeug als Nutzfahrzeug, vorzugsweise als Omnibus, und der erste Leistungskontakt als eine Ladeschnittstelle zum Anschluss einer externen elektrischen Energiequelle ausgeführt sind.

## Claims

1. An electrical power interface of a vehicle, in particular a utility vehicle or a rail vehicle, comprising
a first power contact (11; 31) that can be brought into contact with a second power contact (21; 41) to produce an electrical power path;
an auxiliary contact (14; 34) that is arranged so as to be electrically insulated from the first power contact (11; 31) and that is arranged with respect to the first power contact (11; 31) in such a way that, when the first power contact (11; 31) and the second power contact (21; 41) are brought into contact with one another to form the electrical power path, the auxiliary contact (14; 34) likewise makes contact with the second power contact (21; 41), wherein the auxiliary contact (14; 34) is connected electrically in parallel with the first power contact (11; 31) via a measurement path (3, 4); and
a measurement device for capturing the state of an electrical contact-connection between the first power contact (11; 31) and the second power contact (21; 41) that is configured to determine a voltage drop across the electrical power interface and/or a variable correlating with the voltage drop via the measurement path (3, 4), wherein the measurement device is a voltage measurement device that measures the voltage difference between the auxiliary contact and the first power contact, **characterized by**
a plug (10) that can be brought into contact with a second power contact (21) that is configured as a socket (20), wherein both the first power contact (11) and the auxiliary contact (14) are in the form of a portion of a plug element (10a) of the plug (10) and are connected to one another via an electrically insulating portion (13) of the plug element (10a).

2. The electrical power interface according to Claim 1, **characterized in that** the electrical power interface is a temporary power interface.

3. The electrical power interface according to Claim 1 or 2, **characterized**
**in that** the power interface is a charging interface of a plug-in hybrid vehicle for connecting an external electrical energy source.

4. The electrical power interface according to one of the preceding claims, **characterized**
(a) **in that** the auxiliary contact (14; 34) and the measurement path (3, 4) are configured for currents that are negligibly small in comparison to the first power contact; and/or
(b) **in that** the auxiliary contact (14; 34), the measurement path (3, 4) and/or the measurement device is/are configured in such a way that no current or a negligibly small current flows via the auxiliary contact (14; 34) and the measurement path (3, 4) during measurement of the voltage drop or the variable correlating with the voltage drop by means of the measurement device; and/or
(c) **in that** the measurement path (3, 4) has a first line (3) that is in contact with the first power contact (11; 31), and a second line (4) that is in contact with the auxiliary contact (14; 34).

5. The electrical power interface according to one of the preceding claims, **characterized by** a control device that is designed to reduce the power to be transmitted via the electrical power path or to end the transmission of electrical power via the electrical power path if the voltage drop measured by means of the measurement device under load or the variable correlating with the voltage drop exceeds a predetermined threshold value.

6. The electrical power interface according to one of the preceding claims, **characterized in that** the auxiliary contact (14) is arranged on an end portion of the plug element (10a).

7. The electrical power interface according to Claim 6, **characterized**
(a) **in that** the auxiliary contact (14) is arranged on that end portion of the plug element (10a) that, in the state in which the plug (10) is inserted into the socket (20a), is facing an insertion opening (23) of the socket (20) ; or
(b) **in that** the auxiliary contact is arranged on that end portion of the plug that, in the state in which the plug is inserted into the socket, is facing away from the insertion opening (23) of the socket (20).

8. The electrical power interface according to one of the preceding claims, **characterized in that** the auxiliary contact is provided on a central portion of the plug.

9. A vehicle, in particular utility vehicle or rail vehicle, comprising an electrical power interface according to one of the preceding claims.

10. The vehicle according to Claim 9, **characterized**
**in that** the vehicle is configured as a utility vehicle, preferably as a bus, and the first power contact is configured as a charging interface for connecting an external electrical energy source.

## Revendications

1. Interface de puissance électrique d'un véhicule, en particulier d'un véhicule utilitaire ou d'un véhicule ferroviaire, comprenant
un premier contact de puissance (11 ; 31) qui peut être mis en contact avec un deuxième contact de puissance (21 ; 41) afin d'établir un trajet de puissance électrique ; un contact auxiliaire (14 ; 34) qui est disposé de manière électriquement isolée par rapport au premier contact de puissance (11 ; 31) et qui est disposé par rapport au premier contact de puissance (11 ; 31) de telle sorte que, lorsque le premier contact de puissance (11 ; 31) et le deuxième contact de puissance (21 ; 41) sont mis en contact l'un avec l'autre pour former le trajet de puissance électrique, le contact auxiliaire (14 ; 34) entre également en contact avec le deuxième contact de puissance (21 ; 41), dans lequel le contact auxiliaire (14 ; 34) est connecté électriquement en parallèle avec le premier contact de puissance (11 ; 31) par l'intermédiaire d'un trajet de mesure (3, 4) ; et
un dispositif de mesure destiné à détecter l'état d'un contact électrique entre le premier contact de puissance (11 ; 31) et le deuxième contact de puissance (21 ; 41), qui est conçu pour déterminer, par l'intermédiaire du trajet de mesure (3, 4), une chute de tension au niveau de l'interface de puissance électrique et/ou une grandeur corrélée avec la chute de tension, dans lequel le dispositif de mesure est un dispositif de mesure de tension qui mesure la différence de tension entre le contact auxiliaire et le premier contact de puissance, **caractérisé par**
une fiche (10) qui peut être mise en contact avec un deuxième contact de puissance (21) réalisé sous la forme d'une prise (20), dans lequel le premier contact de puissance (11) et le contact auxiliaire (14) sont tous deux réalisés sous la forme d'une partie d'un élément de fiche (10a) de la fiche (10), et sont connectés l'un à l'autre par l'intermédiaire d'une partie électriquement isolante (13) de l'élément de fiche (10a).

2. Interface de puissance électrique selon la revendication 1, **caractérisée en ce que** l'interface de puissance électrique est une interface de puissance temporaire.

3. Interface de puissance électrique selon la revendication 1 ou 2, **caractérisée en ce que** l'interface de puissance est une interface de charge d'un véhicule hybride rechargeable destinée au raccordement d'une source de puissance électrique externe.

4. Interface de puissance électrique selon l'une quelconque des revendications précédentes, **caractérisée**
(a) **en ce que** le contact auxiliaire (14 ; 34) et le trajet de mesure (3, 4) sont conçus pour des courants négligeables par comparaison au premier contact de puissance ; et/ou
(b) **en ce que** le contact auxiliaire (14 ; 34), le trajet de mesure (3, 4) et/ou le dispositif de mesure sont conçus de telle sorte qu'un courant nul ou négligeable passe par l'intermédiaire du contact auxiliaire (14 ; 34) et du trajet de mesure (3, 4) lorsque la chute de tension ou la grandeur corrélée à la chute de tension est mesurée au moyen du dispositif de mesure ; et/ou
(c) **en ce que** le trajet de mesure (3, 4) comporte une première ligne (3) qui est mise en contact avec le premier contact de puissance (11 ; 31) et une deuxième ligne (4) qui est mise en contact avec le contact auxiliaire (14 ; 34) .

5. Interface de puissance électrique selon l'une quelconque des revendications précédentes, **caractérisée par** un dispositif de commande qui est conçu pour réduire la puissance à transmettre par l'intermédiaire du trajet de puissance électrique ou pour mettre fin à la transmission de puissance électrique par l'intermédiaire du trajet de puissance électrique dans le cas où la chute de tension mesurée au moyen du dispositif de mesure sous charge ou la grandeur corrélée à la chute de tension dépasse une valeur de seuil prédéterminée.

6. Interface de puissance électrique selon l'une quelconque des revendications précédentes, **caractérisée en ce que** le contact auxiliaire (14) est disposé sur une partie d'extrémité de l'élément de fiche (10a).

7. Interface de puissance électrique selon la revendication 6, **caractérisée**
(a) **en ce que** le contact auxiliaire (14) est disposé sur la partie d'extrémité de l'élément de fiche (10a) qui, dans l'état dans lequel la fiche (10) est enfichée dans la prise (20a), est tournée vers une ouverture d'enfichage (23) de la prise (20) ; ou
(b) **en ce que** le contact auxiliaire est disposé sur la partie d'extrémité de la fiche qui est tournée à l'opposé de l'ouverture d'enfichage (23) de la prise (20) dans l'état dans lequel la fiche est enfichée dans la prise.

8. Interface de puissance électrique selon l'une quelconque des revendications précédentes, **caractérisée en ce que** le contact auxiliaire est prévu sur une partie centrale de la fiche.

9. Véhicule, notamment véhicule utilitaire ou véhicule ferroviaire, comprenant une interface de puissance électrique selon l'une quelconque des revendications précédentes.

10. Véhicule selon la revendication 9, **caractérisé en ce que**
le véhicule est réalisé sous la forme d'un véhicule utilitaire, de préférence sous la forme d'un autobus, et **en ce que** le premier contact électrique est réalisé sous la forme d'une interface de charge destinée au raccordement d'une source d'énergie électrique externe.
